(19) Europäisches Patentamt
European Patent Office
Office européen des brevets

(11) EP 1 835 605 A2

(12) **EUROPEAN PATENT APPLICATION**

(43) Date of publication:
19.09.2007 Bulletin 2007/38

(51) Int Cl.:
*H02M 3/335* (2006.01)

(21) Application number: 07005191.7

(22) Date of filing: 13.03.2007

(84) Designated Contracting States:
AT BE BG CH CY CZ DE DK EE ES FI FR GB GR HU IE IS IT LI LT LU LV MC MT NL PL PT RO SE SI SK TR
Designated Extension States:
AL BA HR MK YU

(30) Priority: 14.03.2006 GB 0605065

(71) Applicant: Cambridge Semiconductor Limited
Cambridge CB4 1DL
Cambridgeshire (GB)

(72) Inventor: Coulson, David Robert
Watford WD19 4QW
Bedfordshire (GB)

(74) Representative: Martin, Philip John
Marks & Clerk
66-68 Hills Road
Cambridge,
Cambridgeshire, CB2 1LA (GB)

(54) **Current sensing system for a switch mode power supply**

(57)     A current sensing system for sensing an output current of a Switch Mode Power Supply (SMPS), the SMPS including a magnetic energy storage device for transferring power from an input side to an output side of the SMPS, the current sensing system comprising: a flux model system to generate a waveform representing a magnetic flux in said magnetic energy storage device; and an output current model system to generate , an output current sensing signal responsive to said magnetic flux waveform.

Figure 1a

EP 1 835 605 A2

**Description**

This invention generally relates to apparatus and methods for Switch Mode Power Supply (SMPS) Sensing Systems, more particularly to methods and apparatus for sensing the output current of a Switch Mode Power Supply using primary side sensing.

We will describe improved techniques which enable the design of a Switch Mode Power Supply with a relatively accurately controlled output current limit which, in embodiments, do not need current sensing components on the secondary side of the power supply.

Many SMPS applications require the output current to be either limited to, or maintained at a particular value. One way of achieving this is by including some form of output current sensing, located on the secondary side of the converter, communicating this information back to the power converter controller located on the primary side. This provides an accurate method of current sensing but incurs the cost of additional secondary side components.

A relatively crude current limiting may be implemented by monitoring and limiting the primary side switch current to a particular value. The accuracy may be improved by sensing and integrating the current through the primary switch, correlating the time constant of the integrator to the switching period, in this way estimating the output current. However, the accuracy of output current sensing in this way is dependent, among other things, upon the efficiency of power conversion, the switching time of the switch and the like.

Background prior art relating to SMPS output current control can be found in:
US 6,833,692: Method and apparatus for maintaining an approximate constant current output characteristic in a switched mode power supply; US 6,781,357: Method and apparatus for maintaining a constant load current with line voltage in a Switch Mode Power Supply; US 6,977,824: Full-Text Control circuit for controlling output current at the primary side of a power converter; US 6,977,824: Control circuit for controlling output current at the primary side of a power converter; US 6,862,194; Flyback power converter having a constant voltage and a constant current output under primary-side PWM control; US 6,853,563: Primary-side controlled flyback power converter; US 6,625,042: Power supply arrangement comprising a DC/DC converter with primary-side control loop; and US 4,739,462: Power supply with noise immune current sensing.

We will describe improved techniques for sensing the output current of an SMPS, and for measuring the output current by means of primary side sensing.

According to the present invention there is therefore provided a current sensing system for sensing an output current of a Switch Mode Power Supply (SMPS), the SMPS including a magnetic energy storage device for transferring power from an input side to an output side of the SMPS, the current sensing system comprising: a flux model system to generate a waveform representing a magnetic flux in said magnetic energy storage device; and an output current model system to generate an output current sensing signal responsive to said magnetic flux waveform.

In preferred embodiments of this and later described aspects of the invention the waveform representing the magnetic flux is sensed by sensing a current through a primary-side winding, in particular a primary winding, of the magnetic energy storage device, which may comprise a transformer. In embodiments this current through the winding is sensed by sensing the voltage across a current sensing resistor.

Thus in preferred embodiments the energy storage device has a primary side coupled to the input side of the SMPS and a secondary side coupled to the output side of the SMPS, and the SMPS includes a power switch for switching power to the primary side of the energy storage device (for transferring power from the input to the output side in the usual manner of an SMPS), and a controller for controlling the power switch. In the context of such an arrangement in preferred embodiments the flux model system then further comprises a current sense input to receive a current sense signal responsive to current flowing in the primary side of the energy storage device, and a power switch timing input to receive a power switch timing signal, for example a signal which substantially corresponds to a drive signal for the power switch, The flux model system may then further comprise a flux waveform generator to generate the magnetic flux waveform, more particularly to generate a first (for example rising) part of the flux waveform when the power switch is on and a second (for example falling) part of the flux waveform when the power switch is off, the rates of change or, slopes of the first and second (for example rising and falling) parts of the flux waveform being responsive to the current sense signal. Thus typically the magnetic flux waveform is generally triangular with substantially linear rising and falling portions, this modelling of flux in the energy storage device. Thus the flux waveform represents that the flux in the energy storage device gradually builds up whilst the power switch is on and current is supplied to the primary side of the energy storage device, and then gradually decays when the power switch is off and power is drawn from the secondary side of the energy storage device to contribute to the output current from the SMPS.

The drive control signal for the power switch may be used to control when the magnetic flux waveform ramps up and down, so that it ramps up when the power switch is on. Whilst the power switch is on the current through the primary side of the energy storage device is ramping up, sensed by the current sense signal. Preferably a first portion of the ramp is used to control a rate at which the flux waveform falls (modelling the secondary side output current). Preferably a second later portion of the current sense signal is then used to control the rising portion of the flux waveform (modelling the build-up of flux in response to the primary side input current. Counter-intuitively controlling the falling part of the flux model waveform using the initial rising part of the current sense signal provides a form of negative feedback which helps to stabilise the flux model system. This technique enables both rising and falling parts of the flux model waveform generated from a current sense signal which, in effect, has only a rising part. Moreover the technique pulls the magnetic flux waveform into amplitude (more particularly, voltage level) lock with the current sense signal.

In some preferred embodiments a signal-level-locked loop, more particularly a voltage-locked loop is implemented using a (triangle) waveform generator which has controllable up and down ramp rates. The up ramp rate is controlled by integrating an error signal dependent upon a difference between the magnetic flux waveform and current sense signal, and the down ramp rate is similarly controlled, the integration is being performed over a second part and a first part of the current sense signal respectively. Preferably these two portions of the current sense signal are substantially equal in duration; they may be derived, for example, by comparing the current sense signal with a reference which is midway between the start and end points of its ramp. As previously mentioned, whether the waveform generator ramps up or down may be controlled according to whether the power switch is on or off. Optionally a reset input may be provided to the waveform generator to reset the flux waveform, for example to zero, at a point in the SMPS cycle at which the flux is known to be zero. Such a point may correspond, for example, to a point when the secondary side current is known to be zero.

In preferred embodiments the output current model system comprises an averager to average the magnetic flux waveform over a period when this waveform represents decreasing magnetic flux in the energy storage device, that is when a current is flowing in (out of) the secondary side of the energy storage device). This period may be determined from the flux waveform itself or, for example, may be approximated by the timing of the power switch (at least in a continuous conduction mode). Alternatively a period when an output current is flowing in the secondary side of the energy storage device may be determined by monitoring the energy storage device using an auxiliary winding. In some preferred embodiments the current model system has an input to receive a signal indicating when such a secondary side current is flowing (which is different to the substantially continuous output current of the SMPS itself), this signal being used to gate the magnetic flux waveform into a low pass filter with a relatively long time constant so that the output of the filter represents a time-averaged output current from the SMPS.

The invention also provides an SMPS including a current sensing system as described above. Preferably the energy storage device has an auxiliary winding, as mentioned above, to generate a voltage signal which can be used to determine when a secondary side current is flowing in the energy storage device. The voltage waveform from such an auxiliary winding falls gradually whilst secondary side current is flowing until a knee is reached at which point the voltage drops rapidly to zero. The current timing signal may be derived by identifying this knee, either directly or, for example, by counting backwards from when this auxiliary voltage reaches zero by a quarter of a cycle of the ringing which then follows. This signal, which indicates when the secondary side current falls to zero, may optionally be used to reset the waveform generator generating the magnetic flux waveform or, alternatively a separate reset signal may be derived.

In another aspect the invention provides a system to generate a waveform representing a level of magnetic-flux in an magnetic energy storage device, the system comprising: an input to receive a signal sensing a current flowing through a winding of said magnetic energy storage device; a system output to output said magnetic flux level waveform; a first error detector having a first enable input to, when enabled, determine a first control signal responsive to a difference between said magnetic flux level waveform and said current sensing signal; and a second error detector having a second enable input to, when enabled, determine a second control signal responsive to a difference between said magnetic flux level waveform and said current sensing signal; a magnetic flux waveform generator configured to generate a generally triangular waveform, said waveform generator having: a rising ramp control input coupled to said first error detector to control a rate of a rising ramp part of said generally triangular waveform responsive to said first control signal, and a falling ramp control input coupled to said second error detector to control a rate of a falling ramp part of said generally triangular waveform responsive to said second control signal, a third timing control input to control a timing of said rising and falling ramp parts of said generally triangular waveform, and an output for said generally triangular waveform, coupled to said system output.

In a related aspect the invention provides a method of sensing the output current of a Switch Mode Power Supply (SMPS) by sensing on the primary side of a magnetic energy storage device of said SMPS, the method comprising: generating a waveform representing a level of magnetic flux in said energy storage device by said primary side sensing; and generating a signal representing an output current of said SMPS from said magnetic flux waveform.

Preferably the method includes controlling rates of rising and falling parts of the flux waveform using the primary side sensing, more particularly using an initial rate of rise of primary side current to determine a rate of fall of the flux waveform. As mentioned above, preferably the output signal current is generated by averaging the magnetic flux waveform over a period when flux in the energy storage device is decreasing (secondary side current is flowing); this may be performed by switching or gating the magnetic flux waveform into a low pass filter.

The skilled person will understand that the above described systems and methods may be implemented using processor control code. Thus the invention further provides such processor control code, in particular on a carrier medium such as a disk programmed memory, or on a data carrier such as an optical or electrical signal carrier. The code may comprise conventional computer program code (either source, object or executable, high or low level) and/or code for setting up or controlling an ASIC or FPGA, or code for a hardware description language such as RTL (Register Transfer Level) code, VeriLog™, VHDL, SystemC or similar.

In a further aspect the invention provides a system for sensing the output current of a Switch Mode Power Supply (SMPS) by sensing on the primary side of a magnetic energy storage device of said SMPS, the system comprising; means for generating a waveform representing a level of magnetic flux in said energy storage device by said primary side sensing; and means for generating a signal representing an output current of said SMPS from said magnetic flux waveform.

The skilled person will further understand that the above described systems and methods may be employed in a wide variety of SMPS architectures including (but not limited to) a flyback converter, and a direct-coupled boost converter. The SMPS may operate in either a Discontinuous Conduction Mode (DCM) or in a Continuous Conduction Mode (CCM) or at the boundaries of the two in a Critical Conduction Mode. These and other aspects of the invention will now be further described, by way of example only, with reference to the accompanying figures in which:

> Figures 1a to 1d show, respectively, a block diagram of a Switch Mode Power Supply incorporating a current sensing system according to an embodiment of the invention, an example mains power supply input, an example volt output voltage sense circuit, and an outline block diagram of an example SMPS controller;
>
> Figure 2 shows an embodiment of a flux model system for the current sensing system of Figure 1a;
>
> Figure 3 shows an embodiment of an output current model system for the current sensing system of Figure 1a;
>
> Figure 4 shows a set of waveforms for the current sensing system of Figure 1a when the SMPS is operating in a discontinuous conduction mode (DCM); and
>
> Figure 5 shows a set of waveforms for the current sensing system of Figure 1a when the SMPS is operating in a continuous conduction mode (CCM).

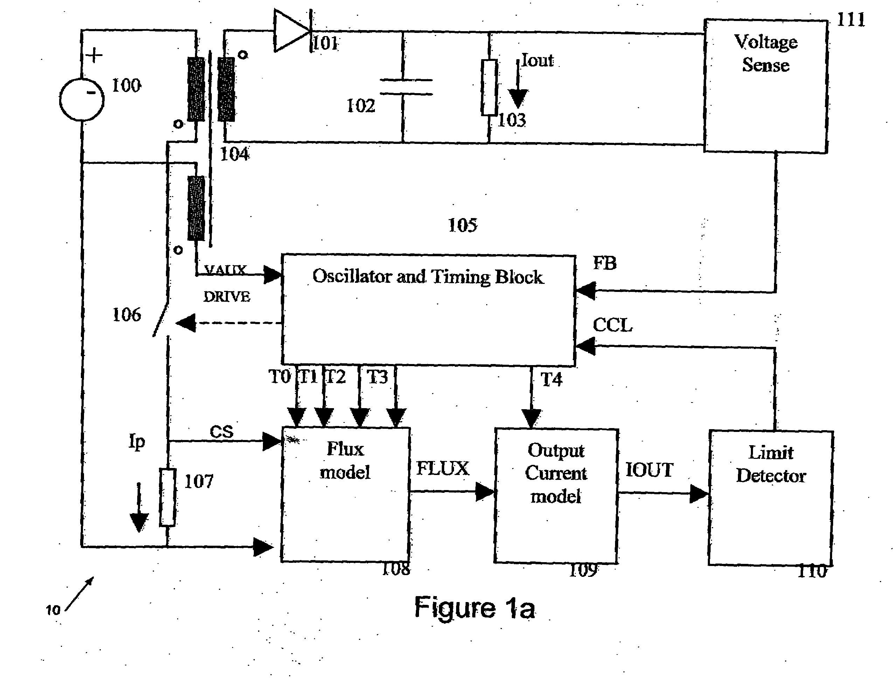

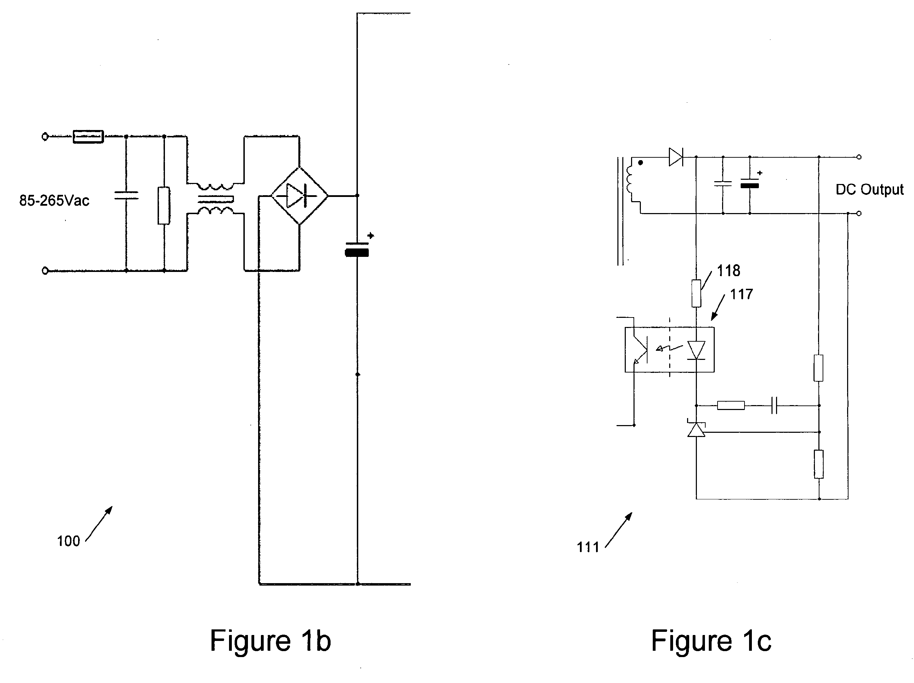

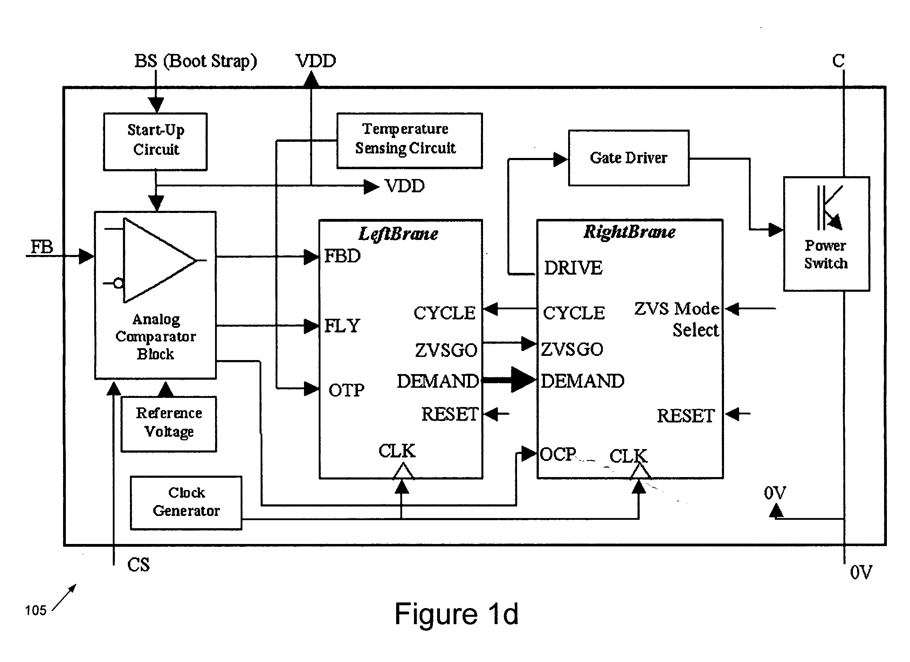

Referring to Figure 1 a, this shows a block diagram of an example single-switch flyback SMPS incorporating a current sensing system embodying aspects of the present invention. In this example circuit a DC source 100 is connected to the primary winding of a transformer 104 in series with a primary side switch 106 and a current sensing resistor 107. The secondary winding of the transformer 104 is connected to an output diode 101 in series with a capacitor 102. A load, represented by a resistor 103 is connected across the output capacitor 102. An auxiliary winding on the transformer 104 is connected between the negative terminal of the DC supply 100 and a flux model system 108 generating a signal VAUX. The primary current IP produces a voltage across resistor 107, generating a signal CS.

Figures 1b and 1c illustrate, by way of example only, a DC source 100 and a voltage sensing circuit 111 respectively. In the example DC source a (domestic grid) mains power supply input is rectified to provide the DC power. In the example voltage sensing circuit the DC output voltage of the SMPS drives a current through a resistor 118 and opto-isolator 117 to a reference voltage generated by a linear shunt regulator.

The transistor of the opto isolator passes a current which depends upon the sensed output voltage of the SMPS.

Figure 1d shows an example oscillator and timing block, more particularly an internal block diagram of an integrated circuit of the applicant. For the purposes of describing the present invention the details of this block are not important (generation of the control signals T0 - T4 is described later), except that the feedback FB generates a demand signal (DEMAND) which controls an oscillator which provides a DRIVE signal output to a power switch, as illustrated comprising an IGBT (Insulated Gate Bipolar Transistor). The DEMAND signal may control either or both of a pulse width and pulse frequency of the DRIVE signal. For further details reference may be made to the applicant's co-pending applications PCT/GB2005/050244, PCT/GB2005/050242, GB 0513772,4, and GB 0526118.5 (all of which applications are hereby incorporated by reference in their entirety),

To aid in understanding embodiments of the invention and the context in which they operate a generalised SMPS will be described. Broadly speaking, a SMPS comprises an energy transfer device for transferring energy cyclically from an input to an output of the power supply (in a flyback regulator design), a power switching device coupled to the input of the power supply and to the energy transfer device, and a control system for controlling the power switching device. The power switching device has a first state in which energy is stored in the energy transfer device and a second state for transferring the stored energy to the power supply output. Typically the energy transfer device comprises an inductor or transformer and the power switching device is controlled by a series of pulses, the transfer of power between the input and the output of the power supply being regulated by either pulse width modulation and/or pulse frequency modulation.

The control system controls the power switching device in response to a feedback signal to regulate the output voltage of the power supply by regulating the energy transferred per cycle. There are many ways of deriving a feedback signal for the control system to regulate the power supply. Direct feedback from the power supply output may be employed, generally with some form of isolation between the output and input such as an opto-isolator or pulse transformer. Alternatively, if a transformer is used as the energy transfer device, an additional or auxiliary winding on the transformer can be used to sense the reflected secondary voltage, which approximates to the power supply output voltage.

In a discontinuous conduction (DCM) mode of operation the energy stored in the energy transfer device falls to substantially zero between power switching cycles (and where the energy transfer device comprises a transformer then the secondary current goes to approximately zero between each cycle). In a continuous conduction (CCM) mode of operation the energy transferred in one cycle depends upon that transferred in previous cycles (and where the energy transfer device comprises a transformer the secondary current does not fall to zero). Embodiments of the techniques we describe may be used in both these modes, and in a critical conduction mode in which the power switch is closed just as the secondary current (stored energy) falls to zero.

Referring again to Figure 1a, the flux model system 108 generates a signal (or value) FLUX representing the level of flux in the transformer, from signals CS, T0, T1, T2 and T3 (described later). The output current model 109 generates a signal (or value) IOUT representing the value of output current. In the example SMPS circuit shown, a voltage sensor 111 compares the output voltage Vout with a reference voltage Vref to generate a feedback signal FB (although other arrangements, for example primary-side sensing, may alternatively be employed). In the example shown, a limit detector 110 compares IOUT with a limiting value (predetermined and/or adjustable), generating an output CCL which gates the oscillator 105, thereby achieving a constant current output characteristic.

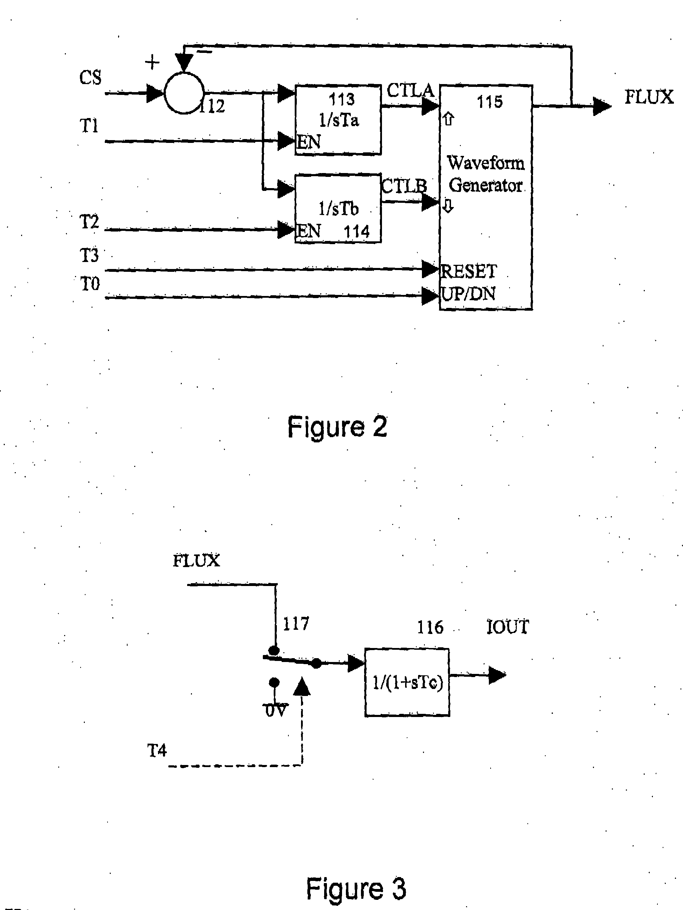

Referring now to Figure 2, this shows the main functional blocks of the flux model system, which together comprise a triangular waveform generator 115 with independent control for the rising and falling ramp waveform sections. This provides an output waveform FLUX, which is voltage-locked to the CS input waveform.

The waveform generator 115 has up and down-slope control inputs receiving respective signals CTLA, CTLB and generates up and down-slopes proportional to the analogue voltages on these respective inputs. The triangular output waveform FLUX is subtracted from CS and the difference integrated to provide the CTLA and CTLB signals. In this way the (voltage) amplitude of the FLUX waveform is locked to the (voltage) amplitude of the CS waveform. The waveform generator 115 also has a RESET input driven by signal T3 which, when active resets the triangle waveform (down-slope) to zero. A further input, UP/DN is provided by signal T0 and controls whether the waveform generator 115 generates a rising or falling ramp.

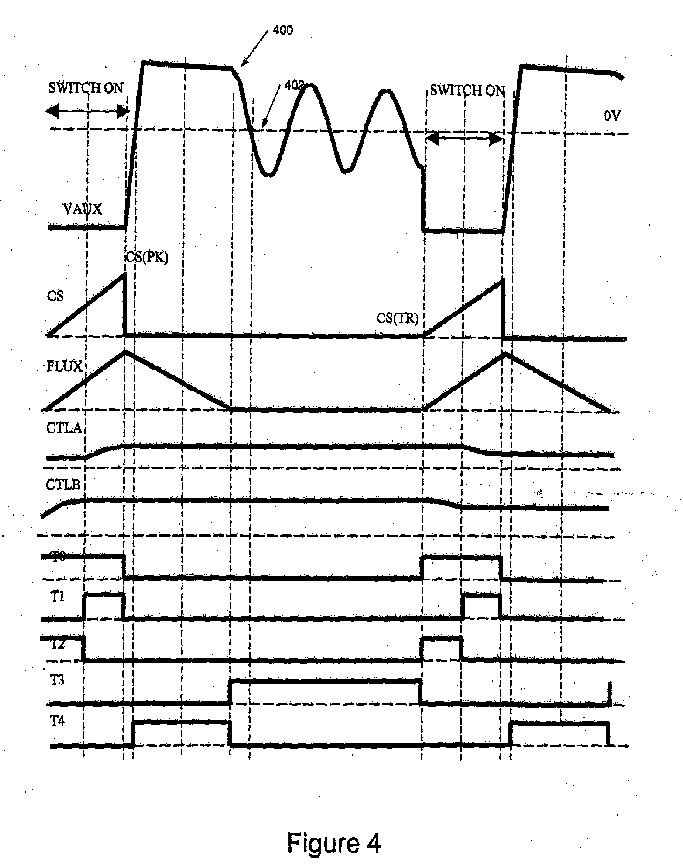

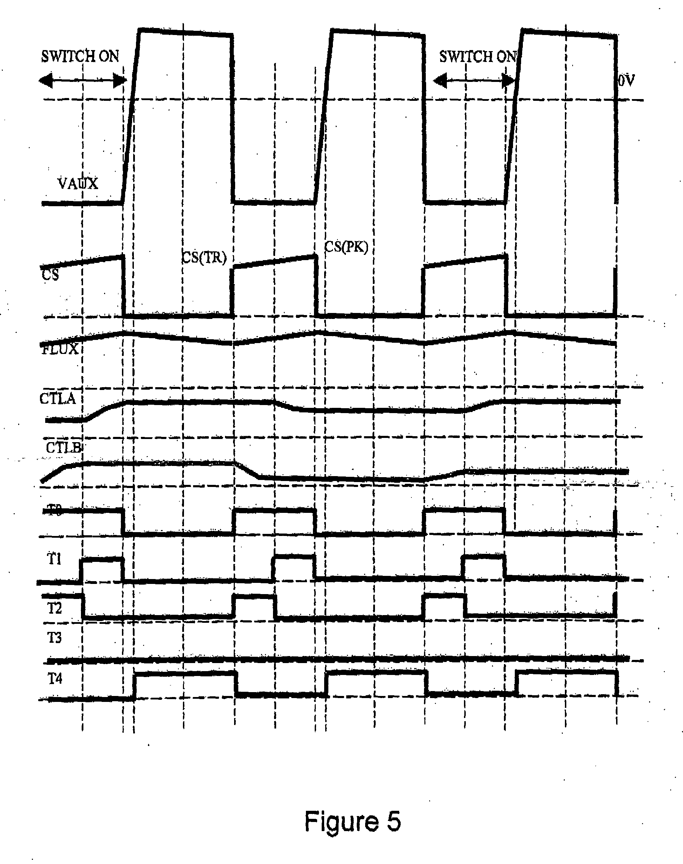

In more detail, the summing junction 112 subtracts the FLUX value from the CS signal value, generating a small error value. This error value is integrated by two error integrators, 113 and 114, which generate CTLA and CTLB values (shown greatly expanded in the waveforms of Figures 4 and 5), which together with T0 and T3 control the ramp generator 115. The positive error integrator 113 is gated by timing signal T1, such that the error signal is integrated when T1 is active high (see Figure 4). Similarly the negative error integrator 114 is gated by timing signal T2, such that the error value is integrated when T2 is active high. The flux model loop output FLUX is fed back and compared with the incoming CS signal (as described above) so that the FLUX waveform closely models the measured CS signal during the on-time of the primary switch.

It is helpful at this stage to refer to the timing diagram of Figures 4 and 5 (which refer to DCM and to CCM respectively). Referring first to the T0 waveform, this corresponds to the DRIVE signal to the power switch 106 of Figure 1a. Whilst T0 is active (high) the power switch is closed and the CS waveform, which is proportional to the current through the primary side of transformer 104, rises linearly. In DCM mode (Figure 4) the primary side current starts from zero; in CCM mode (Figure 5) the linear rise begins from a non-zero value (because the stored energy in the transformer does not fall to zero). The values of CS at the start and end of the linear rise ate labelled CS (TR) and CS (PK), referring to trough and peak values respectively. When signal T0 goes low the primary side current (CS) falls immediately to zero.

Referring next to the FLUX waveform, this rises linearly together with CS and then falls linearly when the power switch is open (T0 is low), as secondary side current is drawn reducing the energy stored in transformer 104, As previously described, in its rising portion (more specifically, in the T 1 part of its rising portion) the FLUX waveform is amplitude (voltage) locked to CS. In the falling part of the FLUX waveform, in DCM mode (Figure 4) the FLUX falls to zero as does the secondary side current (although not IOUT) through Load 103 of Figure 1a, because of storage capacitor 102). In CCM mode the FLUX waveform (and secondary side current) does not fall to zero before the next power switching cycle begins. In both cases it can be seen that the FLUX waveform climbs when T0 is active (high) and falls when T0 is low.

Referring again to Figure 4 (DCM mode) it can be seen that the FLUX waveform falls to zero at the knee 400 in the curve of VAUX (auxiliary winding voltage) against time. This is also the time at which the secondary side current falls to zero. Following this point VAUX exhibits ringing, first passing through zero at point 402, a quarter of a cycle of the ringing on (later) than point 400. As described further below in connection with the output current model, a signal is generated to indicate when secondary side current is flowing; this is signal T4. To generate T4 the knee 400 of the VAUX curve can be identified, for example using the techniques described in PCT/GB2005/050242 *(ibid).* Additionally or alternatively zero crossing 402 can be identified and (for example by keeping sampled values of VAUX in a shift register) the point a quarter of a ringing cycle before this can be identified to generate a transition of T4 (once the period of the ringing cycle has been measured). In a further alternative signal T4 may be initiated by the opening of the power switch (signal T0) and terminated by zero crossing 402 which, as can be seen from Figure 4, approximates the true knee position 400. Signal T4 may thus be generated by a zero-current detector (not shown in Figure 1a) configured to implement any of these techniques, to detect a discharge time of the secondary side switching current via the auxiliary winding of the transformer 104.

In DCM mode an optional RESET signal (T3) may also be generated. This can be used to reset the triangle waveform generator 115 of Figure 2 at a point (either point 400 or 402) at which the secondary side current is known to be zero). This signal is not needed in CCM mode because the secondary side current (FLUX) does not fall to zero. It is also not essential in DCM mode since the operation of the voltage (amplitude)-locked loop of Figure 2 substantially ensures that the FLUX waveform falls to zero when the secondary side current falls to zero, although the T3 signal may be employed to zero any residual signal. Inspection of the timing diagram of Figure 4 shows that T3 may straightforwardly be generated from T4 (going high when T4 goes low and reset low, for example, when T0 goes high).

Referring next to timing signals T1 arid T2, it can be seen that in both Figure 4 and Figure 5 these signals have the same format, T2 being active (high) during the first part of the power switch on period (T0 active-high), and T1 being active (high) during the second part of T0. As described later, the transition between T2 and T1 active may be defined by the midpoint between the trough and peak values of CS mentioned above. Thus T2 and T1 approximately symmetrically divide the power switch on period (T0). During period T2 the FLUX model 108 (Figure 2) integrates the difference between the FLUX waveform and the CS waveform to generate a slope control signal (CTLB) for the down-slope of the waveform generator 115. During the later period T1 the FLUX model integrates the error between the FLUX waveform and the CS waveform to generate an up-slope control signal (CTLA). Controlling the down-slope of the FLUX waveform with the first part (half) of the CS waveform and the up-slope of the FLUX waveform with the second part (half) of the CS rising slope helps to pull the FLUX model system 108 of Figure 2 into lock. The skilled person will readily appreciate that one of the T1 and T2 signals, for example T1, may be generated by comparing the FLUX waveform with a reference midway between (stored) peak and trough CS values. The other of these signals, for example T2, may then be generated by selecting that part of T0 (corresponding to the DRIVE signal) which is not T1.

Continuing to refer to Figures 4 and 5, as mentioned above, although CTLA and CTLB show changes during the switching cycle, which keep the FLUX waveform in amplitude (voltage) lock with the CS waveform, the vertical scale is greatly exaggerated and in practice these changes are small. Now referring back to Figure 3, we next describe the output current model 109. This output current model generates a signal representing the average output current value IOUT of the SMPS from the FLUX waveform output from the FLUX model system 108.

Referring to Figure 3, the FLUX signal is switched by switch 117 which is controlled by timing signal T4, and averaged by the averaging block 116 to generate the value (signal) IOUT. In some preferred embodiments, the averaging block comprises a single pole filter with constant Tc (which is longer than the SMPS switching cycle). Signal T4 is active during the transformer discharge time, as shown in Figure 4, so that the value IOUT accurately represents the average output current. A value for IOUT is not shown on Figures 4 and 5 but would be an essentially constant signal (on the timescale shown), rising slightly whilst T4 is active and decaying slightly thereafter, in accordance with a low pass filtered version of the falling ramp of the FLUX waveform.

The skilled person will recognise that this IOUT signal may be used in a variety of different ways. One example application shown in Figure 1a has IOUT as the input to a limit detector 110, which may comprise a simple comparator. In this example application when the value of IOUT reaches a preset limit a signal (CCL) is output from the limit detector 110, and this can be used to control the oscillator in oscillator and timing block 105, to limit the output current of the SMPS (as described above) - T4 by the oscillator and timing block lOS. The signals are generated as shown in Figures 4 and 5, for DCM and CCM respectively.

> T0 functionally corresponds to the primary switch state, being active when the primary switch 106 is closed.

> T1 goes active high at a point during the on-time of the primary switch, preferably when the FLUX value reaches the mean value of the peak and trough values CS(PK) and CS(TR), and goes inactive at the same time as T0 goes inactive.

> T2 is a logical function of signals T0 and T1, such that:

$$T2 = T0 \;\&\; !T1$$

T3 goes active at the end of the transformer discharge period (preferentially on the next transition of the VAUX through zero) and remains high until the primary switch closes at the start of the next cycle.

T4 goes active high at the start of the transformer discharge time (preferentially when the VAUX signal first passes through zero after the on-time of the primary switch), and goes inactive at the end of the transformer discharge period (preferentially on the next transition of VAUX through zero).

In some preferred embodiments the majority of the SMPS and current sensing system, in particular blocks 105, 108,109, 110, is implemented on a single integrated circuit, preferably together with power switching device 106; the hardware circuitry itself may be generated, for example, from an RTL-level functional description as indicated above.

Broadly speaking we have described a method and system of generating a model waveform of the FLUX of a transformer (or other magnetic energy storage device) in an SMPS. The method/system uses a triangular ramp generator with independent control for the rising and falling ramp waveform portions, which is preferably amplitude (voltage)-locked to the primary current waveform. Thus an amplitude (voltage)-locked loop generates a model FLUX waveform representing the total FLUX in the transformer. An oscillator generates a switching signal for switching the power converter, and a zero-current detector detects a discharge time of a secondary-side switching current by means of an auxiliary winding of the transformer. An averaging block averages the FLUX model waveform during the transformer discharge time. The integrated value is proportional to the output current of the power converter. Embodiments of this system and method provide a relatively low cost method of accurately estimating the output current of an SMPS. Embodiments work in both DCM and CCM modes and have the potential for improved accuracy. This is because embodiments are substantially independent of the effects of variations in the characteristics of the power switch and system efficiency.

No doubt many other effective alternatives will occur to the skilled person. It will be understood that the invention is not limited to the described embodiments and encompasses modifications apparent to those skilled in the art lying within the spirit and scope of the claims appended hereto.

## Claims

1. A current sensing system for sensing an output current of a Switch Mode Power Supply (SMPS), the SMPS including a magnetic energy storage device for transferring power from an input side to an output side of the SMPS, the current sensing system comprising:

   a flux model system to generate a waveform representing a magnetic flux in said magnetic energy storage device; and
   an output current model system to generate an output current sensing signal responsive to said magnetic flux waveform.

2. A current sensing system as claimed in claim 1 wherein said energy storage device has a primary side and a secondary side respectively coupled to said input and to said output side of said SMPS, the SMPS further including a power switch for switching power to said primary side of said energy storage device for transferring power from said input to said output side of said SMPS, and a controller for controlling said power switch, and wherein said flux model system further comprises;

   a current sense input to receive a current sense signal responsive to a current in said primary side of said magnetic energy storage device;
   a power switch timing input to receive from said controller a signal responsive to a timing of said switching of said power switch; and
   a flux waveform generator coupled to said current sense input and to said power switch timing input and configured to generate a first part of said flux waveform when said power switch timing signal indicates power is switched to said primary side of said energy storage device and to generate a second part of said flux waveform when said power switch timing signal indicates power to said primary side of said energy storage device is switched off, and wherein rates of change of said first and second parts of said flux waveform are responsive to said current sense signal.

3. A current sensing system as claimed in claim 2 wherein said rate of change of said first part of said flux waveform is determined by a first portion of said current sense signal during a period when power is switched to said energy storage device, wherein said rate of change of said second part of said flux waveform is determined by a second portion of said current sense signal during a period when power is switched to said energy storage device, wherein said second portion of said current sense signal precedes said first portion of said current sense signal.

**4.** A current sensing system as claimed in claim 3 wherein during said first portion of said current sense signal said flux waveform generator is configured to servo a level of said flux waveform to a level of said current sense signal.

**5.** A current sensing system as claimed in claim 3 or 4 wherein said first and second portion of said current sense signal substantially equally divide, in time, said period when power is switched to said energy storage device.

**6.** A current sensing system as claimed in any preceding claim wherein said output current model system comprises an averager to average said magnetic flux waveform over a period when said waveform represents decreasing magnetic flux in said energy storage device.

**7.** A current sensing system as claimed in any preceding claim wherein said energy storage device has a primary side and a secondary side respectively coupled to said input and output sides of said SMPS, and wherein said current model system has a secondary side current flow timing input to receive a current flow timing signal indicating when an output current is flowing in said secondary side of said energy storage device, and wherein said current model system further comprises a low pass filter and a gate coupled to an input of said low pass filter to selectively input said magnetic flux waveform to said low pass filter when said secondary side output current is flowing.

**8.** An SMPS including the current sensing system of any preceding claim.

**9.** An SMPS as claimed in claim 8 when depending upon claim 6 or 7 wherein said energy storage device comprises a transformer with an auxiliary winding, the SMPS further comprising a system to generate said current flow timing signal responsive to a voltage on said auxiliary winding.

**10.** An SMPS as claimed in claim 8 or 9 wherein said energy storage device comprises a transformer with an auxiliary winding, and wherein said flux model system is configured to reset said magnetic flux waveform responsive to a voltage on said auxiliary winding indicating that a flux in said energy storage device has fallen substantially to zero.

**11.** A system to generate a waveform representing a level of magnetic flux in an magnetic energy storage device, the system comprising:

an input to receive a signal sensing a current flowing through a winding of said magnetic energy storage device;

a system output to output said magnetic flux level waveform;

a first error detector having a first enable input to, when enabled, determine a first control signal responsive to a difference between said magnetic flux level waveform and said current sensing signal; and

a second error detector having a second enable input to, when enabled, determine a second control signal responsive to a difference between said magnetic flux level waveform and said current sensing signal;

a magnetic flux waveform generator configured to generate a generally triangular waveform, said waveform generator having: a rising ramp control input coupled to said first error detector to control a rate of a rising ramp part of said generally triangular waveform responsive to said first control signal, and a falling ramp control input coupled to said second error detector to control a rate of a falling ramp part of said generally triangular waveform responsive to said second control signal, a third timing control input to control a timing of said rising and falling ramp parts of said generally triangular waveform, and an output for said generally triangular waveform, coupled to said system output.

**12.** A method of sensing the output current of a Switch Mode Power Supply (SMPS) by sensing on the primary side of a magnetic energy storage device of said SMPS, the method comprising:

generating a waveform representing a level of magnetic flux in said energy storage device by said primary side sensing; and
generating a signal representing an output current of said SMPS from said magnetic flux waveform.

**13.** A method as claimed in claim 12 wherein said magnetic flux waveform has rising and falling parts respectively representing storing energy into a primary side of said energy storage device and discharging energy from a secondary side of said energy storage device to an output of said SMPS, the method further comprising controlling a rate of said rising part of said flux waveform and a rate of said falling part of said flux waveform responsive to said primary side sensing.

**14.** A method as claimed in claim 13 wherein, during said storing of said energy, a first rate of rise of current flowing in said primary side determines said rate of said falling part of said flux waveform and a second, later rate of rise of said current determines said rate of said rising part of said flux waveform.

**EP 1 835 605 A2**

**15.** A method as claimed in claim 12,13 or 14 wherein said output current signal generating comprises averaging said magnetic flux waveform over a period when flux in said magnetic energy storage device is decreasing.

**16.** A method as claimed in claim 15 wherein said averaging comprises gating said magnetic flux waveform into a low pass filter whilst said flux is decreasing.

**17.** A system for sensing the output current of a Switch Mode Power Supply (SMPS) by sensing on the primary side of a magnetic energy storage device of said SMPS, the system comprising:

means for generating a waveform representing a level of magnetic flux in said energy storage device by said primary side sensing; and means for generating a signal representing an output current of said SMPS from said magnetic flux waveform.

**18.** A carrier carrying processor control code to, when running, implement the method of any one of claims 12 to 16.

Figure 1a

Figure 1c

Figure 1b

Figure 1d

CS

T1

CTLA

113
1/sTa

EN

115

FLUX

CTLB

1/sTb

T2

EN 114

Waveform
Generator

T3

RESET

T0

UP/DN

## Figure 2

FLUX

117

116 IOUT

1/(1+sTc)

0V

T4

## Figure 3

Figure 4

Figure 5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6833692 B
- US 6781357 B
- US 6977824 B
- US 6862194 B
- US 6853563 B
- US 6625042 B
- US 4739462 A
- GB 2005050244 W
- GB 2005050242 W
- GB 05137724 A
- GB 0526118 A